(19) Europäisches Patentamt
European Patent Office
Office européen des brevets

(11) **EP 3 840 049 A1**

(12) **DEMANDE DE BREVET EUROPEEN**

(43) Date de publication:
**23.06.2021   Bulletin 2021/25**

(51) Int Cl.:
***H01L 27/24*** *(2006.01)*

(21) Numéro de dépôt: **20213584.4**

(22) Date de dépôt: **11.12.2020**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
**KH MA MD TN**

(30) Priorité: **16.12.2019   FR 1914468**

(71) Demandeur: **Commissariat à l'Energie Atomique et aux Energies Alternatives**
**75015 Paris (FR)**

(72) Inventeur: **VERDY, Anthonin**
**38054 GRENOBLE CEDEX 09 (FR)**

(74) Mandataire: **Cabinet Camus Lebkiri**
**25 rue de Maubeuge**
**75009 Paris (FR)**

(54) **CELLULE ELEMENTAIRE COMPORTANT UNE MEMOIRE RESISTIVE ET PROCEDE D'INITIALISATION ASSOCIE**

(57)     Un aspect de l'invention concerne une cellule (100) élémentaire comportant une couche de claquage (103) en diélectrique ayant une épaisseur dépendant d'une tension de claquage, un dispositif et une mémoire (102) résistive non volatile montés en série, le dispositif (101) comportant :
- une électrode supérieure de sélecteur (1013),
- une électrode inférieure de sélecteur (1011),
- une couche réalisée dans un premier matériau actif, dite couche active sélectrice (1012),
ledit dispositif (101) étant destiné à former un sélecteur volatil ;
ladite mémoire (102) comportant :
- une électrode supérieure de mémoire (1015),
- une électrode inférieure de mémoire (1013),
- une couche réalisée dans au moins un second matériau actif, dite couche active mémoire (1014).

FIG.3

**Description**

**DOMAINE TECHNIQUE DE L'INVENTION**

Le domaine technique de l'invention est celui des cellules élémentaires comportant une mémoire résistive en série avec un dispositif sélecteur.

La présente invention concerne une cellule élémentaire comportant une mémoire résistive en série avec un dispositif destiné à former un sélecteur. La présente invention concerne également un procédé d'initialisation d'une telle cellule.

**ARRIERE-PLAN TECHNOLOGIQUE DE L'INVENTION**

Pour des applications qui nécessitent un stockage de l'information résistant aux coupures de tension, des mémoires résistives non volatiles réinscriptibles sont couramment utilisées. Celles-ci sont basées sur des matériaux actifs tels que des matériaux à conduction ionique (mémoires CBRAM ou « Conductive Bridging RAM »), à oxydes métalliques (mémoires OxRAM ou « Oxide Resistive RAM »), ferroélectriques (mémoires FERAM ou « Ferroelectric RAM »), magnétiques (mémoires MRAM ou « Magnetic RAM), magnétiques à transfert de spin (mémoires STTRAM ou « Spin Torque Transfer RAM ») ou encore à changement de phase (mémoires PCRAM ou « Phase Change RAM »). Ces mémoires sont des mémoires de type résistives, c'est-à-dire qu'elles peuvent présenter au moins deux états résistifs correspondant à un état fortement résistif (état « HRS » pour « High Résistance State ») et à un état faiblement résistif (état « LRS » pour « Low Résistance State ») sous l'application d'une tension.

Les mémoires résistives ont besoin de deux électrodes pour fonctionner. Par exemple, les mémoires CBRAM comportent une zone active basée sur un matériau à conduction ionique formant un électrolyte solide à conduction ionique disposé entre une électrode formant une cathode inerte et une électrode comportant une portion de métal ionisable, c'est-à-dire une portion de métal pouvant facilement former des ions métalliques, et formant une anode. Le fonctionnement des mémoires CBRAM est basé sur la formation, au sein de l'électrolyte solide, d'un ou plusieurs filaments métalliques (appelés également « dendrites ») entre ses deux électrodes lorsque ces électrodes sont portées à des potentiels appropriés. La formation du filament permet d'obtenir une conduction électrique donnée entre les deux électrodes. En modifiant les potentiels appliqués aux électrodes, il est possible de modifier la répartition du filament, et de modifier ainsi la conduction électrique entre les deux électrodes.

Les mémoires PCRAM comportent une zone active basée sur un matériau chalcogénure. Le fonctionnement des mémoires PCRAM est basé sur la transition de phase du matériau chalcogénure, induite par l'échauffement de ce matériau sous l'effet d'impulsions électriques spécifiques appliquées entre les deux électrodes. Cette transition se fait entre une phase cristalline, ordonnée, de faible résistance et thermodynamiquement stable et une phase amorphe, désordonnée, de résistance élevée et thermodynamiquement instable.

Les mémoires OxRAM présentent une structure M-I-M (Métal-Isolant-Métal) comprenant un matériau actif de résistance électrique variable, en général un oxyde de métal de transition (ex. $HfO_2$, $Ta_2O_5$, $TiO_2$...), disposé entre deux électrodes métalliques. Le passage de l'état « HRS » à l'état « LRS » est gouverné par la formation et la rupture d'un filament conducteur de section nanométrique entre les deux électrodes.

Les mémoires résistives présentent notamment l'intérêt de pouvoir s'intégrer avec de fortes densités, via une intégration de type « cross-bar » (désignée également par la terminologie « cross-point »).

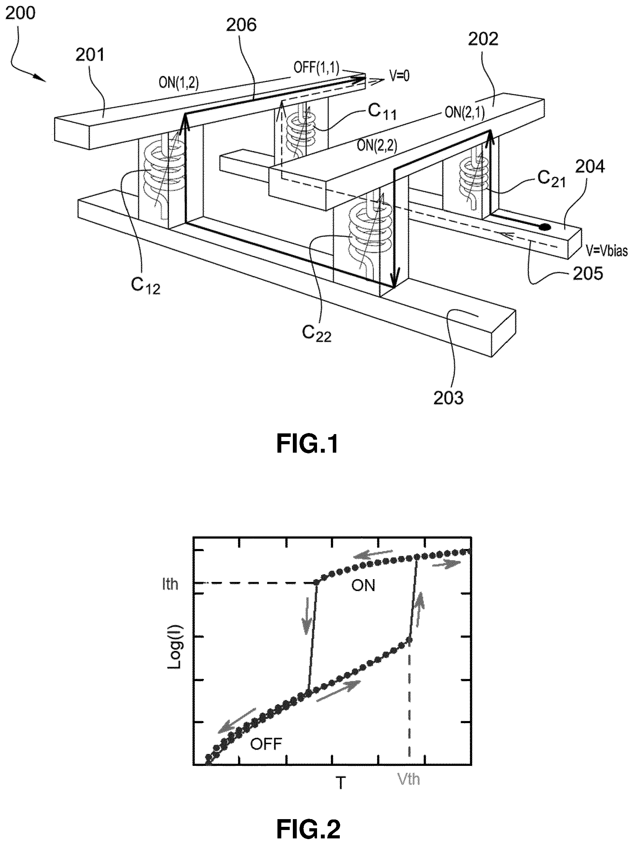

[Fig 1] Une telle architecture 200 est illustrée sur la figure 1 et comporte une pluralité de lignes d'accès 201, 202, 203, 204 et une pluralité de cellules mémoires (ici quatre cellules C11, C21, C22, C12) non volatiles réinscriptibles basées sur des matériaux actifs (par exemple des cellules CBRAM). Les lignes d'accès sont formées par des lignes de bits 201, 202 parallèles supérieures et des lignes de mots 203, 204 inférieures perpendiculaires aux lignes de bits, les cellules élémentaires C11, C21, C22, C12 étant prises en sandwich à l'intersection entre les lignes de bits 201, 202 et les lignes de mots 203, 204. L'architecture 200 forme ainsi un réseau où chaque cellule mémoire est adressable individuellement, en sélectionnant la bonne ligne de bits et la bonne ligne de mots.

Pour éviter les courants de fuite parasites passant par les cellules adjacentes lors de la phase de lecture de l'état d'une cellule réalisée par polarisation de la ligne et de la colonne souhaitées, il est connu d'ajouter en série avec chacune des cellules, un dispositif sélecteur. Dans ce cas, les dispositifs sélecteurs bloquent le passage du courant parasite, autorisant ainsi uniquement le courant induit par la polarisation de la ligne de bits et la ligne de mots (application d'une différence de potentiel Vbias entre ces deux lignes).

Dans la littérature, on retrouve différents types de dispositifs sélecteurs comme les FAST (pour « Field Assisted Superlinear Threshold »), les MIEC (pour « Mixed-Ionic-Electronic Conduction ») et les OTS (pour « Ovonic Threshold Switching »). Un dispositif sélecteur est composé de deux électrodes et d'un matériau actif, les électrodes étant disposées de part et d'autre du matériau actif et permettant d'appliquer une tension à ce matériau actif. Dans le cas d'un sélecteur de type OTS, le matériau actif peut être un alliage chalcogénure, généralement dans un état amorphe.

[Fig 2] Le principe de base du fonctionnement d'un dispositif sélecteur est représenté à la figure 2. Le dispositif est très résistif dans l'état OFF. Dès qu'on lui applique une tension supérieure à une tension de seuil, le courant augmente rapidement pour atteindre l'état ON du dispositif, un état bassement résistif. Dès que le courant ou la tension est réduit au-dessous d'une valeur spécifique dite de maintien ou de « holding », le dispositif redevient OFF.

Pour diminuer la tension de seuil d'un dispositif sélecteur, il peut être possible de diminuer l'épaisseur de la couche de matériau actif du sélecteur ou de modifier la composition du matériau actif, notamment en diminuant la largeur de sa bande interdite et donc l'énergie de bande associée. La diminution de la largeur de bande peut s'effectuer en utilisant des atomes lourds tels que Sb, Si, Sn ou Te qui présentent le désavantage de diminuer la température de cristallisation du matériau. Lorsque la température de cristallisation est inférieure aux températures d'intégration, le matériau actif cristallise et sort de fabrication dans un état faiblement résistif ou état conducteur et ne joue donc pas son rôle de sélecteur consistant à empêcher le passage des courants parasites, c'est-à-dire à isoler électriquement la mémoire.

Il existe donc un besoin d'obtenir un ensemble comprenant une mémoire résistive et un dispositif sélecteur, dans lequel la mémoire est isolée électriquement, quel que soit l'état résistif de la mémoire et l'état résistif du dispositif sélecteur en sortie de fabrication.

**RESUME DE L'INVENTION**

L'invention offre une solution aux problèmes évoqués précédemment, en permettant d'obtenir une cellule avec une mémoire résistive en série avec un dispositif sélecteur sans problème d'isolation électrique de la mémoire à partir de la sortie de fabrication.

Un premier aspect de l'invention concerne une cellule élémentaire comportant un dispositif et une mémoire résistive non volatile montés en série, le dispositif comportant :

- une électrode supérieure de sélecteur,
- une électrode inférieure de sélecteur,
- une couche réalisée dans un premier matériau actif, dite couche active sélectrice,

ledit dispositif étant destiné à former un sélecteur volatil passant d'un premier état résistif de sélecteur à un deuxième état résistif de sélecteur par application d'une tension de seuil de sélecteur entre l'électrode supérieure de sélecteur et l'électrode inférieure de sélecteur et repassant au premier état résistif de sélecteur dès que le courant le traversant ou la tension aux bornes de l'électrode supérieure de sélecteur et l'électrode inférieure de sélecteur redevient respectivement inférieur à un courant ou une tension de maintien, le premier état résistif de sélecteur étant plus résistif que le deuxième état résistif de sélecteur,

ladite mémoire comportant :

- une électrode supérieure de mémoire,

- une électrode inférieure de mémoire,
- une couche réalisée dans au moins un second matériau actif, dite couche active mémoire,

ladite mémoire passant d'un premier état résistif de mémoire à un deuxième état résistif de mémoire par application d'une tension de seuil de mémoire entre l'électrode supérieure de mémoire et l'électrode inférieure de mémoire,

ladite cellule comportant en outre une couche de claquage de matériau diélectrique montée en série avec le dispositif et la mémoire, ayant une épaisseur permettant le claquage de la couche de claquage à une tension de claquage prédéterminée lorsque ladite tension de claquage est appliquée entre l'électrode supérieure de mémoire et l'électrode inférieure de sélecteur.

Grâce à l'invention, la couche de claquage isolante joue le rôle du sélecteur après la sortie de fabrication, c'est-à-dire qu'elle réalise l'isolation électrique de la mémoire quel que soit son état résistif en sortie de fabrication. L'épaisseur de la couche de claquage est choisie pour permettre son claquage lors de l'application d'une tension de claquage prédéterminée. La couche de claquage cesse alors d'être résistive et de jouer le rôle de sélecteur.

On entend par « couche de claquage », une couche réalisée dans un matériau isolant électriquement destiné à devenir au moins en partie conducteur à l'application d'une tension électrique minimale, appelée tension de claquage.

Le premier état résistif de sélecteur correspond à l'état OFF du dispositif sélecteur, le deuxième état résistif de sélecteur correspond à l'état ON du dispositif sélecteur et le premier et le deuxième état résistif de mémoire correspondent aux états HRS et LRS de la mémoire résistive, définis précédemment.

Outre les caractéristiques qui viennent d'être évoquées dans le paragraphe précédent, la cellule selon le premier aspect de l'invention peut présenter une ou plusieurs caractéristiques complémentaires parmi les suivantes, considérées individuellement ou selon toutes les combinaisons techniquement possibles.

Selon une variante de réalisation, l'épaisseur de la couche de claquage est le rapport de la tension de claquage et d'un champ de claquage du matériau diélectrique de la couche de claquage.

Ainsi, l'épaisseur de la couche de claquage dépend du matériau diélectrique la composant.

Selon une variante de réalisation compatible avec la variante de réalisation précédente, la tension de claquage est comprise entre une tension de lecture choisie supérieure à la tension de seuil de sélecteur et à la tension de seuil de mémoire, et une tension de programmation au moins égale à la somme de la tension de seuil de sélecteur et de la tension de seuil de mémoire.

Ainsi, la tension de claquage est suffisante pour claquer la couche de claquage et initialiser la mémoire sans l'endommager.

Selon une variante de réalisation compatible avec les variantes de réalisation précédentes, le dispositif est destiné à former un sélecteur de type OTS.

Selon une variante de réalisation compatible avec les variantes de réalisation précédentes, la mémoire résistive est de type PCRAM, OxRAM ou CBRAM.

Selon une variante de réalisation compatible avec les variantes de réalisation précédentes, la couche active sélectrice est dans un état conducteur cristallin.

Ainsi, dans le cas où le matériau de la couche active sélectrice a une température de cristallisation inférieure aux températures d'intégration, le dispositif sélecteur est dans un état conducteur en sortie de fabrication et ne joue donc pas son rôle de sélecteur consistant à isoler électriquement la mémoire.

Selon une variante de réalisation compatible avec les variantes de réalisation précédentes, l'électrode supérieure de sélecteur est confondue avec l'électrode inférieure de mémoire.

Selon une variante de réalisation compatible avec les variantes de réalisation précédentes excepté la variante de réalisation précédente, la couche de claquage est formée entre l'électrode inférieure de mémoire et l'électrode supérieure de sélecteur.

Selon une variante de réalisation compatible avec les variantes de réalisation précédentes excepté la variante de réalisation précédente, la cellule comporte en outre une électrode supérieure de cellule et/ou une électrode inférieure de cellule et la couche de claquage est formée entre l'électrode supérieure de cellule et l'électrode supérieure de mémoire ou entre l'électrode inférieure de cellule et l'électrode inférieure de sélecteur.

Ainsi, la couche de claquage n'est pas directement en contact avec la couche active sélectrice ou avec la couche active mémoire et n'induit donc pas de dispersion des propriétés de la mémoire ou du dispositif sélecteur.

Selon une variante de réalisation compatible avec les variantes de réalisation précédentes, la cellule comporte une couche de carbone entre l'électrode inférieure de sélecteur et la couche active sélectrice et/ou entre l'électrode supérieure de sélecteur et la couche active sélectrice.

Ainsi, l'interaction entre la couche active sélectrice et ses électrodes est limitée et l'endurance du dispositif sélecteur est améliorée.

Un deuxième aspect de l'invention concerne une matrice comportant une pluralité de cellules selon le premier aspect de l'invention, une pluralité de lignes d'accès supérieures et une pluralité de lignes d'accès inférieures, chaque cellule étant située à une intersection entre une ligne d'accès supérieure et une ligne d'accès inférieure permettant son adressage individuel, les cellules voisines de la cellule adressée subissant une tension résiduelle provenant de la cellule adressée.

Ainsi, la cellule selon le premier aspect de l'invention est compatible avec une structure à haute densité d'intégration.

Un troisième aspect de l'invention concerne un procédé d'initialisation d'une cellule selon le premier aspect de l'invention ou de chaque cellule d'une matrice selon le deuxième aspect de l'invention, comportant une étape d'application à la cellule d'un courant d'initialisation et d'une impulsion en tension ayant une intensité égale à la tension de claquage.

Ainsi, l'intensité de l'impulsion d'initialisation permet d'une part le claquage de la couche de claquage qui devient conductrice et ne joue donc plus le rôle de sélecteur, et d'autre part l'initialisation de la mémoire.

Selon une variante de réalisation, si la couche active sélectrice est dans un état conducteur cristallin, l'impulsion a un temps de descente prédéterminé et le courant d'initialisation a une valeur prédéterminée.

Ainsi, le courant appliqué pendant l'initialisation ou courant d'initialisation est choisi pour permettre la fonte de la couche active sélectrice et le temps de descente de l'impulsion est choisi pour permettre la trempe de la couche active sélectrice, ce qui permet l'amorphisation du dispositif sélecteur pour placer le dispositif sélecteur dans son état fortement résistif OFF. Le dispositif sélecteur joue alors le rôle de sélecteur à partir de l'initialisation.

Selon une variante de réalisation compatible avec la variante de réalisation précédente, la tension de claquage est comprise entre une tension de claquage minimale égale à la tension maximale entre la tension de lecture et la tension résiduelle, et une tension de claquage maximale égale à la tension de programmation.

Ainsi, la tension de claquage prend en compte les éventuelles tensions résiduelles au sein de la matrice.

L'invention et ses différentes applications seront mieux comprises à la lecture de la description qui suit et à l'examen des figures qui l'accompagnent.

**BREVE DESCRIPTION DES FIGURES**

Les figures sont présentées à titre indicatif et nullement limitatif de l'invention.

- La figure 1 représente une architecture d'adressage d'une pluralité de cellules mémoires selon l'état de la technique ;
- La figure 2 montre un graphe explicitant le principe de fonctionnement d'un dispositif sélecteur ;
- La figure 3 montre une représentation schématique d'une cellule élémentaire selon le premier aspect de l'invention ;
- La figure 4 montre une représentation schématique de la première étape du procédé de fabrication selon le troisième aspect de l'invention ;
- La figure 5 montre une représentation schématique de la deuxième étape du procédé de fabrication selon le troisième aspect de l'invention ;
- La figure 6 montre une représentation schématique de la troisième étape du procédé de fabrication selon le troisième aspect de l'invention ;

- La figure 7 montre une représentation schématique de la quatrième étape du procédé de fabrication selon le troisième aspect de l'invention ;
- La figure 8 montre une représentation schématique de la cinquième étape du procédé de fabrication selon le troisième aspect de l'invention ;
- La figure 9 montre une représentation schématique de la sixième étape du procédé de fabrication selon le troisième aspect de l'invention ;
- La figure 10 montre une représentation schématique de la septième étape du procédé de fabrication selon le troisième aspect de l'invention ;
- La figure 11 montre une représentation schématique de la huitième étape du procédé de fabrication selon le troisième aspect de l'invention ;
- La figure 12 montre une représentation schématique de la neuvième étape du procédé de fabrication selon le troisième aspect de l'invention permettant d'obtenir une matrice selon le deuxième aspect de l'invention ;
- La figure 13 montre un schéma synoptique représentant l'enchaînement des étapes du procédé de fabrication selon le troisième aspect de l'invention ;
- La figure 14 montre un schéma synoptique représentant l'étape du procédé d'initialisation selon le quatrième aspect de l'invention ;
- La figure 15 montre une courbe illustrant la résistance de la couche active sélectrice d'une cellule en fonction de la densité de courant qui lui est appliqué, chaque point étant mesuré après l'application d'une impulsion rectangulaire ayant une durée de 1 microseconde.
- La figure 16 montre l'intensité traversant la couche active sélectrice d'une cellule élémentaire en fonction de la tension qui lui est appliquée avant et après l'initialisation.
- La figure 17 illustre les tensions résiduelles exercées sur des cellules adressées dans une architecture cross-bar avec une stratégie de polarisation en V/2 à gauche et en V/3 à droite.

**DESCRIPTION DETAILLEE**

Sauf précision contraire, un même élément apparaissant sur des figures différentes présente une référence unique.

Les figures 1 et 2 ont déjà été décrites en référence à l'état de la technique.

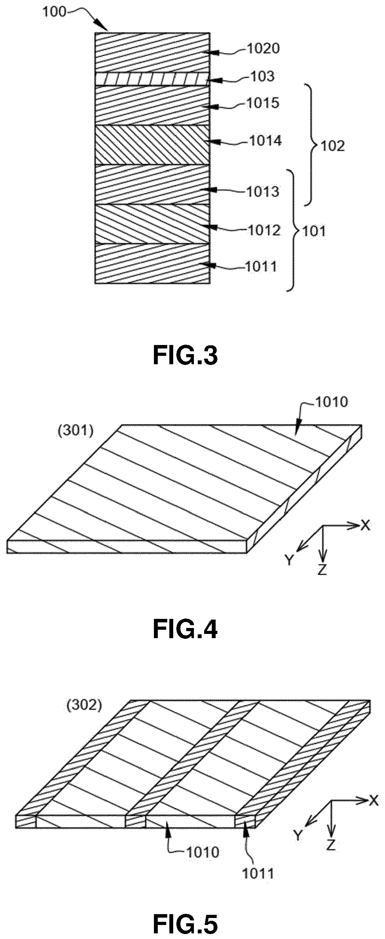

[Fig 3] Un premier aspect de l'invention illustré à la figure 3 concerne une cellule élémentaire 100 comprenant un empilement comprenant un sélecteur et une mémoire résistive 102 non-volatile. Le sélecteur permet l'adressage de la mémoire résistive 102 non-volatile quand elle est intégrée au sein d'une architecture de type cross-bar.

La cellule élémentaire 100 comporte :

- Une couche de matériau conducteur d'électrode inférieure de sélecteur 1011 ;
- Une couche réalisée dans un premier matériau actif, dite couche active sélectrice 1012 ;
- Une couche de matériau conducteur, formant une électrode supérieure de sélecteur et une électrode inférieure de mémoire ;
- Une couche réalisée dans au moins un second matériau actif, dite couche active mémoire 1014 ;
- Une couche de matériau conducteur d'électrode supérieure de mémoire 1015 ;
- Une couche de claquage 103 réalisée dans un matériau diélectrique.

Selon l'exemple de réalisation illustré sur la figure 3, la couche de matériau conducteur d'électrode supérieure de sélecteur et la couche de matériau conducteur d'électrode inférieure de mémoire sont confondues en une seule et même couche 1013 mais il est également possible d'avoir deux couches distinctes pour former ces éléments.

Le premier matériau actif est destiné à former un dispositif sélecteur 101 et le au moins un second matériau actif est apte à former une mémoire résistive 102, le dispositif sélecteur 101 et la mémoire résistive 102 nécessitant chacun une électrode supérieure et une électrode inférieure pour assurer leur fonctionnement.

On définit une électrode supérieure d'un dispositif comme l'électrode située au-dessus de ce dispositif et l'électrode inférieure d'un dispositif comme l'électrode située en dessous de ce dispositif, les électrodes étant situées de part et d'autre du dispositif. Bien entendu, les adjectifs « supérieure » et « inférieure » sont ici relatifs à l'orientation de l'ensemble incluant l'électrode supérieure, le dispositif et l'électrode inférieure si bien qu'en retournant cet ensemble, l'électrode précédemment qualifiée de supérieure devient l'électrode inférieure et l'électrode précédemment qualifiée d'inférieure devient l'électrode supérieure.

Le ou les matériaux de la couche active mémoire 1014 sont choisis en fonction du type de mémoire désiré, par exemple, une mémoire de type PCRAM, OxRAM ou encore CBRAM : ce choix conditionne alors le choix des matériaux conducteurs des électrodes 1013, 1015 de la mémoire 102. En effet, par exemple, pour qu'une CBRAM fonctionne, il lui faut deux électrodes disposées de part et d'autre de son matériau actif à conduction ionique, dont une électrode comportant une portion de métal ionisable, c'est-à-dire une portion de métal pouvant facilement former des ions métalliques. Les électrodes sont par exemple en Ag ou en Cu.

Pour une mémoire PCRAM, le matériau de la couche active mémoire 1014 est par exemple du In-Ge-Sb-Te, Ga-Sb, Ge-Sb, Ga-Sb-Te, Ti-Sb-Te, Ge-Sb-Se-Te, Si-Sb-Te, Ge-Sb-Te, du Sb-Te ou encore du Ge-Te. L'épaisseur de la couche active mémoire 1014 est par exemple comprise entre 50 et 100 nm.

Pour une mémoire CBRAM, le matériau de la couche active mémoire 1014 est par exemple du Ge-S, Ge-Se, Cu-S, Ag-S, Ta-O, Si-O, W-O.

La couche active mémoire 1014 peut comporter par exemple une première sous-couche de $Al_2O_3$ et une deuxième sous-couche de Cu-Te-Ge. La première sous-couche a par exemple une épaisseur de 3,5 nm et la deuxième sous-couche a par exemple une épaisseur de 20 nm.

Pour une mémoire OxRAM, le matériau de la couche active mémoire 1014 est par exemple du Hf-O, Ta-O, Ti-O, Al-O.

La couche active mémoire 1014 peut comporter par exemple une première sous-couche de $HfO_2$ et une deuxième sous-couche de Ti. La première sous-couche a par exemple une épaisseur de 5 à 10 nm et la deuxième sous-couche a par exemple une épaisseur de 5 à 10 nm.

Avant initialisation, c'est-à-dire en sortie de fabrication, la couche active sélectrice 1012 est, par exemple, dans un état cristallin conducteur, c'est-à-dire dans un état faiblement résistif.

Le matériau de la couche active sélectrice 1012 est par exemple choisi pour que le dispositif sélecteur 101 à former soit de type OTS. Par exemple, la couche active sélectrice 1012 est réalisée en Ge-Se, As-Te-Al, Ge-Se-Te, Ge-Se-Sb, As-Ge-Te, As-Ge-Te-Si, Si-Te, C-Te, Al-Te, B-Te, Ge-Te, As-Ge-Se-Si ou encore en As-Ge-Se-Te. La couche active sélectrice 1012 est par exemple dopée avec du N, C, O, P ou encore H. L'épaisseur de la couche sélectrice 1012 est par exemple de 15 à 50 nm.

Les propriétés du sélecteur, comme sa tension seuil ou son intensité de maintien, peuvent être ajustées par l'épaisseur et la composition de la couche active sélectrice 1012.

La couche active sélectrice 1012 peut être prise en sandwich entre deux couches de carbone. Les couches de carbone ont par exemple une épaisseur de 3 à 15 nm.

Le matériau utilisé pour les électrodes 1011, 1013, 1015 est par exemple du TiN, du TaN, du W, du Cu, du TiWN, du TiSiN ou encore du WN. Les électrodes 1011, 1013, 1015 peuvent toutes être composées d'un même matériau ou bien être composées de matériaux différents.

La couche de claquage 103 peut être formée entre l'électrode inférieure de mémoire 1013 et l'électrode supérieure de sélecteur 1013 si ces deux électrodes sont non confondues.

La cellule 100 peut également comporter une électrode inférieure distincte de l'électrode inférieure de sélecteur 1011 et/ou une électrode supérieure 1020 distincte de l'électrode supérieure de mémoire 1015. Dans ce cas, selon une première variante de réalisation, la couche de claquage 103 est par exemple formée entre l'électrode supérieure 1020 et l'électrode supérieure de mémoire 1015 ou selon une deuxième variante de réalisation, entre l'électrode inférieure et l'électrode inférieure de sélecteur 1011.

L'épaisseur de la couche de claquage 103 dépend d'une tension de claquage choisie de manière à permettre le claquage permanent du matériau diélectrique de la couche de claquage 103 quand elle est appliquée à la cellule 100.

La tension de claquage doit être supérieure ou égale à une tension de lecture choisie pour la cellule 100.

On entend par « tension de lecture », la tension appliquée à la cellule 100 pour lire l'état de la mémoire résistive 102 de la cellule. La tension de lecture est supérieure à la tension de seuil de la mémoire 102 et à la tension de seuil du dispositif sélecteur 101.

La tension de claquage doit également être inférieure ou égale à une tension de programmation au moins égale à la somme de la tension de seuil de la mémoire 102 et de la tension de seuil du dispositif sélecteur 101.

La couche de claquage 103 est par exemple réalisée en dioxyde de silicium $SiO_2$, en dioxyde de titane $TiO_2$, en dioxyde d'hafnium $HfO_2$ ou encore en dioxyde de nickel $NiO_2$.

Chaque matériau diélectrique présente un champ de claquage, s'exprimant en V/cm. Le dioxyde de silicium $SiO_2$ a par exemple un champ de claquage de $7 \times 10^6$ V/cm quand il est déposé par PVD à température ambiante.

L'épaisseur de la couche de claquage 103 dépend par exemple du champ de claquage du matériau diélectrique qui compose la couche de claquage 103. L'épaisseur de la couche de claquage 103 est par exemple le rapport de la tension de claquage et du champ de claquage du matériau diélectrique.

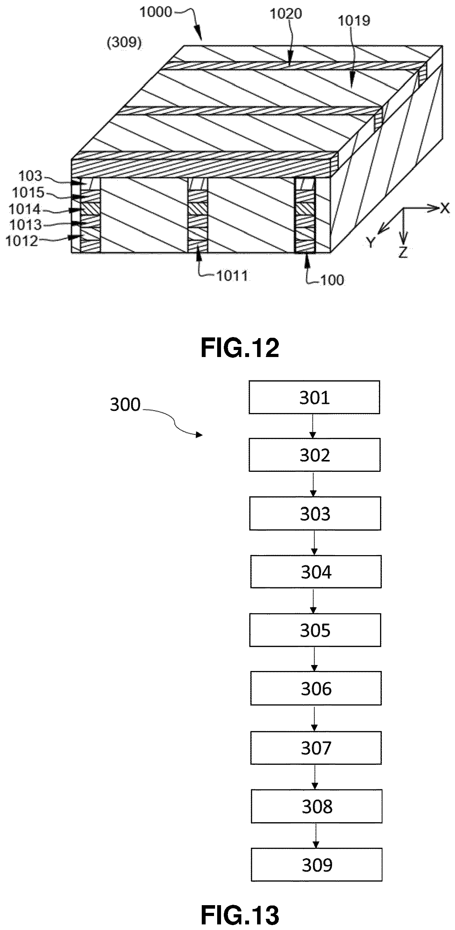

[Fig 12] Un deuxième aspect de l'invention concerne une matrice 1000 illustrée à la figure 12 comportant une pluralité de cellules élémentaires 100 selon le premier aspect de l'invention.

La matrice 1000 est une architecture de type cross-bar, c'est-à-dire qu'elle possède une pluralité de lignes d'accès supérieures 1020 ou lignes d'accès, une pluralité de lignes d'accès inférieures 1011 ou colonnes d'accès et une cellule 100 à chaque intersection entre une ligne d'accès supérieure 1020 et une ligne d'accès inférieure 1011.

La matrice 1000 forme ainsi un réseau où chaque cellule 100 est adressable individuellement, en polarisant la ligne d'accès inférieure 1011 et la ligne d'accès supérieure 1020 que la cellule 100 intersecte.

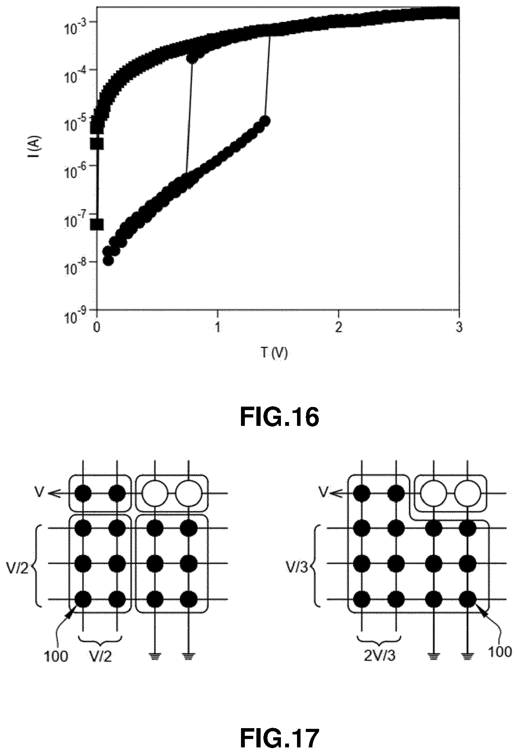

[Fig 17] La figure 17 illustre deux stratégies de polarisation pour adresser des cellules 100 dans une architecture de type cross-bar.

La première stratégie illustrée à gauche consiste à polariser la ligne d'accès des cellules 100 à adresser avec la tension V souhaitée, à mettre les colonnes d'accès des cellules 100 à la masse et à polariser les autres lignes et colonnes d'accès avec une tension égale à V/2.

La deuxième stratégie illustrée à droite consiste à polariser la ligne d'accès des cellules 100 à adresser avec la tension V souhaitée, à mettre les colonnes d'accès des cellules 100 à la masse, à polariser les autres lignes avec une tension égale à V/3 et les autres colonnes d'accès avec une tension égale à 2V/3.

Ces stratégies de polarisation créent des tensions résiduelles égales à la différence entre la tension exercée sur la ligne d'accès et la tension exercée sur la colonne d'accès. Ainsi, pour la première stratégie, les cellules 100 situées sur la même ligne d'accès ou sur les mêmes colonnes d'accès que les cellules 100 adressées ont une tension résiduelle égale à V/2. Pour la deuxième stratégie, toutes les cellules 100 représentées autres que les cellules adressées ont une tension résiduelle égale à V/3.

Ainsi, la tension de claquage doit également être supérieure ou égale à la tension résiduelle exercée par les cellules 100 voisines sur la cellule 100 pour éviter le claquage non volontaire des cellules 100 voisines non adressées.

Prenons l'exemple d'une couche active sélectrice 1012 en AsTeAlN ayant une épaisseur de 50 nm permettant d'obtenir un dispositif sélecteur 101 ayant une tension de seuil de 3 V, d'une couche active mémoire 1014 en GST 225 ayant une épaisseur de 50 nm permettant d'obtenir une mémoire PCM ayant une tension de seuil de 1 V et une couche de claquage 103 en $SiO_2$ ayant un champ de claquage de 7 MV/cm. La stratégie de polarisation est de type V/2.

Comme précisé précédemment, la tension de claquage doit être inférieure ou égale à la tension de programmation égale à la somme des tensions de seuil, c'est-à-dire à 4 V et la tension de claquage doit être supérieure ou égale à la tension de lecture, elle-même supérieure à la tension de seuil du dispositif sélecteur 101, c'est-à-dire à 3 V, à la tension de seuil de la mémoire 102, c'est-à-dire à 1 V, ainsi qu'à la tension résiduelle, c'est-à-dire à 2 V en considérant la tension maximale appliquée lors de d'adressage, à savoir la tension de programmation.

Si l'on choisit une tension de lecture de 3.5 V, la tension de claquage est comprise entre 3.5 et 4 V.

Une fois la tension de claquage choisie, en considérant le cas où l'épaisseur de la couche de claquage 103 est le rapport de la tension de claquage et du champ de claquage du matériau diélectrique, l'épaisseur de la couche de claquage 103 est comprise entre 5 et 5.7 nm.

[Fig 13] La figure 13 est un schéma synoptique illustrant l'enchaînement des étapes 301 à 309 d'un procédé 300 de de la matrice selon le deuxième aspect de l'invention.

[Fig 4] La figure 4 illustre la première étape 301 du procédé 300, qui consiste à réaliser un dépôt conforme d'une première couche de matériau diélectrique 1010. Un dépôt conforme signifie que le matériau est déposé de manière uniforme sur l'ensemble d'une surface. Le plan selon lequel s'étend la première couche de matériau diélectrique 1010 contient la direction $\vec{X}$ et la direction $\vec{Y}$. Le repère orthogonal $(\vec{X}\,;\vec{Y}\,;\vec{Z})$ définit les côtés de la matrice 1000 si elle est de forme parallélépipédique rectangle. La dimension des couches selon la direction $\vec{Z}$ est appelée épaisseur.

Le matériau diélectrique de la première couche de matériau diélectrique 1010, comme les matériaux des autres couches de matériau diélectrique sauf la couche de claquage 103, est par exemple du SiN, du $SiO_2$ du SiC, du SiON, du SiCN ou encore SiHN. Le dépôt de cette étape 301 comme ceux des étapes suivantes de dépôts peut être un dépôt physique en phase vapeur ou PVD (pour « Physical Vapor Déposition »), un dépôt chimique en phase vapeur ou CVD (pour « Chemical Vapor Déposition »), ou un dépôt par couche atomique ou ALD (pour « Atomic Layer Déposition »).

[Fig 5] La figure 5 illustre la deuxième étape 302 du procédé 300 consistant à réaliser un damascène de la première couche de matériau diélectrique 1010.

On entend par « damascène » le procédé consistant à remplir de matériau conducteur une tranchée préalablement formée dans un matériau diélectrique suivi d'un polissage mécanochimique.

Le damascène est par exemple réalisé avec du cuivre Cu.

Ainsi, la première couche de matériau diélectrique 1010 comprend des lignes inférieures métalliques 1011, exposées permettant d'établir des contacts métalliques avec une couche supérieure.

Les lignes inférieures métalliques constituent les électrodes inférieures ou les électrodes inférieures de sélecteur 1011 des cellules élémentaires 100 de la matrice 1000.

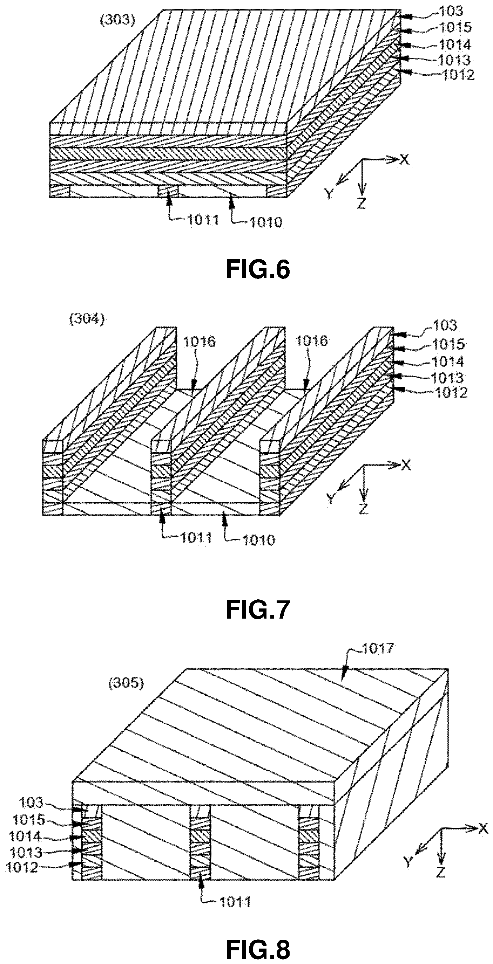

[Fig 6] La figure 6 illustre la troisième étape 303 du procédé 300 consistant à réaliser un dépôt conforme d'une couche active sélectrice 1012, puis un dépôt conforme d'une couche de matériau conducteur 1013 formant à la fois l'électrode supérieure de sélecteur et l'électrode inférieure de mémoire, puis un dépôt conforme d'une couche active mémoire 1014, puis un dépôt conforme d'une couche de matériau conducteur d'électrode supérieure de mémoire 1015.

Dans le cas où l'électrode supérieure de sélecteur est distincte de l'électrode inférieure de mémoire, la troisième étape 303 du procédé 300 comporte le dépôt conforme d'une couche active sélectrice 1012, puis alors un dépôt conforme d'une première couche de matériau conducteur formant l'électrode supérieure de sélecteur, puis d'une deuxième couche de matériau conducteur formant l'électrode inférieure de mémoire, suivi d'un dépôt conforme d'une couche active mémoire 1014, puis un dépôt conforme d'une couche de matériau conducteur d'électrode supérieure de mémoire 1015.

Dans la première variante de réalisation pour la couche de claquage 103 représentée sur la figure 3, la troisième étape 103 comporte un dépôt conforme d'une couche de claquage 103 sur la couche de matériau conducteur d'électrode supérieure de mémoire 1015.

Dans la deuxième variante de réalisation pour la couche de claquage 103 non représentée sur les figures, la troisième étape 103 comporte un dépôt conforme d'une couche de claquage 103 sur la première couche de matériau diélectrique 1010 comprenant des lignes inférieures métalliques 1011 puis un dépôt conforme d'une couche de matériau conducteur formant l'électrode inférieur de sélecteur 1011.

La troisième étape 303 du procédé 300 peut comporter, en supplément, un dépôt conforme d'une première couche de carbone sur la première couche de matériau diélectrique 1010 comprenant des lignes inférieures métalliques 1011 et d'une deuxième couche de carbone sur la couche active sélectrice 1012 de manière à ce que la couche active sélectrice 1012 soit prise en sandwich entre la première et la deuxième couche de carbone.

[Fig 7] La figure 7 illustre la quatrième étape 304 du procédé 300 consistant à graver au moins une première tranchée 1016 avec arrêt sur la première couche de matériau diélectrique 1010.

La gravure est par exemple réalisée par photogravure ou par lithographie.

La première tranchée 1016 s'étend selon sa longueur suivant la direction $\vec{Y}$. La première tranchée 1016 est gravée de manière à ce que les parties non gravées soient sensiblement de même hauteur après gravure. En cas de pluralité de premières tranchées 1016, les premières tranchées 1016 sont toutes parallèles entre elles et la profondeur de gravure est la même pour toutes les premières tranchées 1016.

[Fig 8] La figure 8 illustre la cinquième étape 305 du procédé 300 consistant à encapsuler l'empilement de la figure 7. Plus précisément, cette cinquième étape 305 consiste à remplir les premières tranchées 1016 précédemment gravées et à recouvrir les parties des couches déposées à la troisième étape 303 n'ayant pas été gravées à l'étape de gravure 304 précédente, avec une deuxième couche de matériau diélectrique 1017.

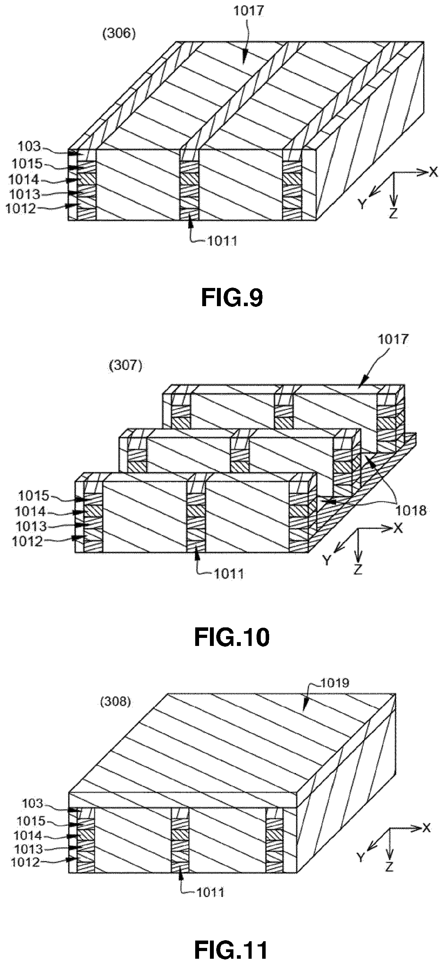

[Fig 9] La figure 9 illustre la sixième étape 306 de planarisation du procédé 300 consistant à retirer de la matière avec arrêt sur les parties des couches déposées à la troisième étape 303 n'ayant pas été gravées lors de l'étape de gravure 304 de manière à obtenir une couche plane, dans un plan contenant les directions $\vec{X}$ et $\vec{Y}$. La planarisation est par exemple réalisée par polissage planarisant.

[Fig 10] La figure 10 illustre la septième étape 307 du procédé 300 consistant à graver au moins une deuxième tranchée 1018 suivant une direction, ici suivant $\vec{X}$, perpendiculaire à $\vec{Y}$, avec arrêt sur la première couche de matériau diélectrique 1010.

En cas de pluralité de deuxièmes tranchées 1018, les deuxièmes tranchées 1018 sont parallèles entre elles et la profondeur de gravure est sensiblement la même pour toutes les deuxièmes tranchées 1018. La deuxième tranchée 1018 est gravée de manière à ce que les parties non gravées soient sensiblement de même hauteur après gravure. La deuxième tranchée 1018 s'étend, selon sa longueur, de manière perpendiculaire à la première tranchée 1016, c'est-à-dire selon l'axe $\vec{X}$.

[Fig 11] La figure 11 illustre la huitième étape 308 du procédé 300 consistant à encapsuler l'empilement illustré par la figure 10. Cette huitième étape 308 consiste à remplir les deuxièmes tranchées 1018 précédemment gravées et à recouvrir les parties des couches déposées à la troisième étape 303 n'ayant pas été gravées aux étapes 304, 308 de gravure, avec une troisième couche de matériau diélectrique 1019.

[Fig 12] La figure 12 illustre la neuvième étape 309 du procédé 300 consistant à réaliser un damascène de la troisième couche de matériau diélectrique 1019 pour former des lignes supérieures métalliques 1020.

A la fin du procédé 300 de fabrication selon le troisième aspect de l'invention, la matrice 1000 comporte une pluralité de cellules élémentaires 100 ayant chacune un dispositif 101 destiné à former un sélecteur mais ne jouant pas le rôle de sélecteur, et une mémoire 102 non initialisée.

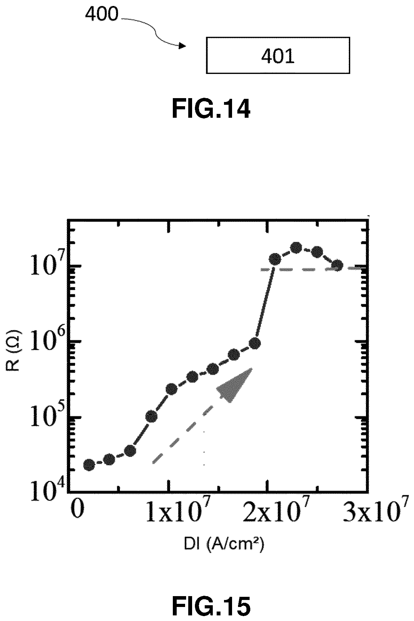

[Fig 14] La figure 14 est un schéma synoptique d'un procédé 400 d'initialisation selon un troisième aspect de l'invention d'une cellule selon le premier aspect de l'invention ou de chaque cellule d'une matrice 1000 selon le deuxième aspect de l'invention.

Une étape 401 du procédé 400 consiste à appliquer une impulsion en tension et un courant d'initialisation à chaque cellule élémentaire 100 pour claquer la couche de claquage 103 de chaque cellule élémentaire 100 et initialiser la mémoire 102. L'impulsion en tension est égale à la tension de claquage et la tension de claquage doit donc être choisie pour assurer l'initialisation ou forming de la mémoire 102.

Dans le cas où la couche active sélectrice 1012 est dans un état conducteur en sortie de fabrication, l'étape 401 du procédé 400 peut également permettre d'amorphiser la couche active sélectrice 1012 de chaque cellule élémentaire 100. Pour cela, le courant d'initialisation doit être choisi pour permettre la fonte de la couche active sélectrice 1012, et l'impulsion a un temps de descente choisi pour permettre la trempe de la couche active sélectrice 1012.

On entend par « temps de descente d'une impulsion », le temps nécessaire pour que l'impulsion passe de 90% de sa valeur maximale à 10% de sa valeur maximale.

L'impulsion est par exemple une impulsion rectangulaire ayant une durée de 1 microseconde et une intensité égale à la tension de claquage choisie. L'impulsion est par exemple une impulsion de programmation standard.

Le courant d'impulsion est par exemple choisi pour que la densité de courant appliquée à la couche active sélectrice 1012 soit de l'ordre de $20 \times 10^6$ A/cm$^2$.

[Fig 15] Sur la figure 15 est représentée la résistance R de la couche active sélectrice 1012 en fonction de la densité de courant DI qui lui est appliquée, chaque point correspondant à l'application d'une impulsion rectangulaire ayant une durée de 1 microseconde. Sur la figure 15, la résistance de la couche active sélectrice 1012, c'est-à-dire son taux d'amorphisation augmente jusqu'à atteindre un palier aux alentours de $20 \times 10^6$ A/cm$^2$. Ainsi, en appliquant une impulsion rectangulaire ayant une durée de 1 microseconde et une densité de courant de $20 \times 10^6$ A/cm$^2$ à la couche active sélectrice 1012, cette dernière s'amorphise complètement.

A l'issue de l'étape 401 du procédé 400, la couche active sélectrice 1012 de chaque cellule 100 est dans un état amorphe et donc le dispositif sélecteur 101 de chaque cellule 100 est dans son état fortement résistif OFF.

[Fig 16] La figure 16 illustre l'intensité traversant la couche active sélectrice 1012 d'une cellule élémentaire 100 en fonction de la tension qui lui est appliquée avant et après l'amorphisation de la couche active sélectrice. Avant l'amorphisation, la couche active sélectrice 1012 se comporte comme un matériau conducteur, c'est-à-dire ayant une résistance inférieure à $1 \times 10^6$ $\Omega$, et après amorphisation, la couche active sélectrice 1012 se comporte comme un dispositif sélecteur, comme illustré à la figure 2.

Ainsi, après amorphisation, le dispositif sélecteur 101 fonctionne comme un sélecteur et la matrice 1000 est alors opérationnelle.

**Revendications**

1. Cellule (100) élémentaire comportant un dispositif (101) et une mémoire (102) résistive non volatile montés en série, le dispositif (101) comportant :

  - une électrode supérieure de sélecteur (1013),
  - une électrode inférieure de sélecteur (1011),
  - une couche réalisée dans un premier matériau actif, dite couche active sélectrice (1012),

ledit dispositif (101) étant destiné à former un sélecteur volatil passant d'un premier état résistif de sélecteur (OFF) à un deuxième état résistif de sélecteur (ON) par application d'une tension de seuil de sélecteur (Vth) entre l'électrode supérieure de sélecteur (1013) et l'électrode inférieure de sélecteur (1011) et repassant au premier état résistif de sélecteur (OFF) dès que le courant le traversant ou la tension aux bornes de l'électrode supérieure de sélecteur (1013) et l'électrode inférieure de sélecteur (1011) redevient respectivement inférieur à un courant (Ih) ou une tension de maintien, le premier état résistif de sélecteur (OFF) étant plus résistif que le deuxième état résistif de sélecteur (ON), ladite mémoire (102) comportant :

  - une électrode supérieure de mémoire (1015),
  - une électrode inférieure de mémoire (1013),
  - une couche réalisée dans au moins un second matériau actif, dite couche active mémoire (1014),

ladite mémoire (102) passant d'un premier état résistif de mémoire à un deuxième état résistif de mémoire par application d'une tension ou d'un courant de seuil de mémoire entre l'électrode supérieure de mémoire (1015) et l'électrode inférieure de mémoire (1013),
ladite cellule (100) comportant en outre une couche de claquage (103) de matériau diélectrique montée en série avec le dispositif (101) et la mémoire (102), ayant une épaisseur permettant le claquage de la couche de claquage (103) à une tension de claquage prédéterminée lorsque ladite tension de claquage est appliquée entre l'électrode supérieure de mémoire (1015) et l'électrode inférieure de sélecteur (1011), ladite cellule (100) étant **caractérisée en ce que** la couche de claquage (103) n'est en contact ni avec la couche active mémoire (1014), ni avec la couche active sélectrice (1012).

2. Cellule (100) selon la revendication 1, **caractérisée en ce que** l'épaisseur de la couche de claquage (103) est le rapport de la tension de claquage et d'un champ de claquage du matériau diélectrique de la couche de claquage (103).

3. Cellule (100) selon l'une quelconque des revendications précédentes, **caractérisée en ce que** la tension de claquage est comprise entre une tension de lecture choisie supérieure à la tension de seuil de sélecteur et à la tension de seuil de mémoire, et une tension de programmation au moins égale à la somme de la tension de seuil de sélecteur et de la tension de seuil de mémoire.

4. Cellule (100) selon l'une quelconque des revendications précédentes, **caractérisée en ce que** le dispositif (101) est destiné à former un sélecteur de type OTS.

5. Cellule (100) selon l'une quelconque des revendications précédentes, **caractérisée en ce que** la mémoire (102) résistive est de type PCRAM, OxRAM ou CBRAM.

6. Cellule (100) selon l'une quelconque des revendications précédentes, **caractérisée en ce que** la couche active sélectrice (1012) est dans un état conducteur cristallin.

7. Cellule (100) selon la revendication 6, **caractérisée en ce que** la couche active sélectrice (1012) est dans un état conducteur cristallin en sortie de fabrication.

8. Cellule (100) selon l'une quelconque des revendications précédentes, **caractérisée en ce que** l'électrode supérieure de sélecteur (1013) est confondue avec l'électrode inférieure de mémoire (1013).

9. Cellule (100) selon l'une quelconque des revendications 1 à 7, **caractérisée en ce que** la couche de claquage (103) est formée entre l'électrode inférieure de mémoire (1013) et l'électrode supérieure de sélecteur (1013).

10. Cellule (100) selon l'une quelconque des revendications 1 à 8, **caractérisée en ce qu'**elle comporte en outre une électrode supérieure de cellule (1020) et/ou une électrode inférieure de cellule et **en ce que** la couche de claquage (103) est formée entre l'électrode supérieure de cellule (1020) et l'électrode supérieure de mémoire (1015) ou entre l'électrode inférieure de cellule et l'électrode inférieure de sélecteur (1011).

11. Cellule (100) selon l'une quelconque des revendications précédentes, **caractérisée en ce qu'**elle comporte une couche de carbone entre l'électrode inférieure de sélecteur (1011) et la couche active sélectrice (1012) et/ou entre l'électrode supérieure de sélecteur (1013) et la couche active sélectrice (1012).

12. Matrice (1000) comportant une pluralité de cellules (100) selon l'une quelconque des revendications précédentes, une pluralité de lignes d'accès supérieures (1020) et une pluralité de lignes d'accès inférieures (1011), chaque cellule (100) étant située à une intersection entre une ligne d'accès supérieure et une ligne d'accès inférieure permettant son adressage individuel, les cellules (100) voisines de la cellule (100) adressée subissant une tension résiduelle provenant de la cellule (100) adressée.

13. Procédé d'initialisation (400) d'une cellule (100) selon l'une quelconque des revendications 1 à 11, ou de chaque cellule (100) d'une matrice (1000) selon la revendication 11, **caractérisé en ce qu'**il comporte une étape (401) d'application à la cellule (100) d'un courant d'initialisation et d'une impulsion en tension ayant une intensité égale à la tension de claquage.

14. Procédé d'initialisation (400) selon la revendication 13, **caractérisé en ce que**, si la couche active sélectrice (1012) est dans un état conducteur cristallin, l'impulsion a un temps de descente prédéterminé et le courant d'initialisation a une valeur prédéterminée.

15. Procédé d'initialisation (400) selon l'une quelconque des revendications 13 à 14, **caractérisé en ce que** la tension de claquage est comprise entre une tension de claquage minimale égale à la tension maximale entre la tension de lecture et la tension résiduelle, et une tension de claquage maximale égale à la tension de programmation.

**FIG.1**

**FIG.2**

**FIG.3**

**FIG.4**

**FIG.5**

**FIG.6**

**FIG.7**

**FIG.8**

FIG.9

FIG.10

FIG.11

FIG.12

FIG.13

400

401

**FIG.14**

**FIG.15**

**FIG.16**

**FIG.17**

**Europäisches Patentamt**
**European Patent Office**
**Office européen des brevets**

# RAPPORT DE RECHERCHE EUROPEENNE

Numéro de la demande

EP 20 21 3584

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2011/310653 A1 (KREUPL FRANZ [DE] ET AL) 22 décembre 2011 (2011-12-22) * alinéa [0121] - alinéa [0156]; figures 6A, 6K1,7A * ----- | 1,5-9,12 | INV. H01L27/24 |
| A | US 2010/091561 A1 (LOWREY TYLER [US] ET AL) 15 avril 2010 (2010-04-15) * alinéa [0162] - alinéa [0234]; figures 3,11 * ----- | 1-15 | |
| A | US 2010/163825 A1 (DENNISON CHARLES H [US] ET AL) 1 juillet 2010 (2010-07-01) * alinéa [0026] - alinéa [0037]; revendication 16; figure 9 * ----- | 1-15 | |

DOMAINES TECHNIQUES RECHERCHES (IPC)

H01L

Le présent rapport a été établi pour toutes les revendications

| Lieu de la recherche | Date d'achèvement de la recherche | Examinateur |
|---|---|---|
| Munich | 2 mars 2021 | Koskinen, Timo |

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 20 21 3584

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-03-2021

| Document brevet cité au rapport de recherche | Date de publication | Membre(s) de la famille de brevet(s) | Date de publication |
|---|---|---|---|
| US 2011310653 A1 | 22-12-2011 | CN 102986048 A | 20-03-2013 |
| | | CN 103003971 A | 27-03-2013 |
| | | CN 103168372 A | 19-06-2013 |
| | | EP 2583322 A2 | 24-04-2013 |
| | | EP 2583323 A2 | 24-04-2013 |
| | | EP 2583324 A1 | 24-04-2013 |
| | | JP 2013534722 A | 05-09-2013 |
| | | JP 2013534723 A | 05-09-2013 |
| | | JP 2013534724 A | 05-09-2013 |
| | | KR 20130036279 A | 11-04-2013 |
| | | KR 20130036292 A | 11-04-2013 |
| | | KR 20130097139 A | 02-09-2013 |
| | | US 2011310653 A1 | 22-12-2011 |
| | | US 2011310654 A1 | 22-12-2011 |
| | | US 2011310655 A1 | 22-12-2011 |
| | | US 2011310656 A1 | 22-12-2011 |
| | | WO 2011159581 A2 | 22-12-2011 |
| | | WO 2011159582 A2 | 22-12-2011 |
| | | WO 2011159583 A2 | 22-12-2011 |
| | | WO 2011159584 A1 | 22-12-2011 |
| US 2010091561 A1 | 15-04-2010 | TW 200633204 A | 16-09-2006 |
| | | US 2006097240 A1 | 11-05-2006 |
| | | US 2010091561 A1 | 15-04-2010 |
| | | WO 2006052846 A2 | 18-05-2006 |
| US 2010163825 A1 | 01-07-2010 | AUCUN | |

EPO FORM P0460

Pour tout renseignement concernant cette annexe : voir Journal Officiel de l'Office européen des brevets, No.12/82